Europäisches Patentamt

European Patent Office

Office européen des brevets

(11) Publication number: **0 441 238 A2**

# (12) EUROPEAN PATENT APPLICATION

(21) Application number: **91101240.9**

(22) Date of filing: **31.01.91**

(51) Int. Cl.5: **C25D 5/10, C25D 3/56, B32B 15/01, H05K 1/00**

(30) Priority: **05.02.90 JP 25495/90**

(43) Date of publication of application:
**14.08.91 Bulletin 91/33**

(84) Designated Contracting States:
**DE FR GB SE**

(71) Applicant: **MITSUI MINING & SMELTING CO., LTD.**
**1-1, Muromachi 2-chome Nihonbashi, Chuo-ku**
**Tokyo 103(JP)**

(72) Inventor: **Mase, Kazuo**
**No. 11-14, Nogata 1-chome**
**Nakano-ku, Tokyo(JP)**
Inventor: **Tanaka, Kiminori**
**No. 1380-1-B-110, Haraichi**
**Ageo-shi, Saitama-ken(JP)**
Inventor: **Mitsuhashi, Masakazu**
**No. 2278-92, Komuro, Inamachi**
**Kitaadachi-gun, Saitama-ken(JP)**

(74) Representative: **Liebau, Gerhard, Dipl.-Ing.**
**Birkenstrasse 39 Postfach 22 02 29**
**W-8900 Augsburg 22(DE)**

(54) Electrodeposited invar composite foil.

(57) An invar composite foil made by electrodepositing invar on both sides of metal foil at the same time. Preferably copper is further electrodeposited on at least one of the invar layers as necessary according to applications. This composite foil does not contain oil. Broad foil can be mass-produced at a low cost. Furthermore, this foil is virtually not curled and easy to handle in the manufacturing and working process.

# EP 0 441 238 A2

## ELECTRODEPOSITED INVAR COMPOSITE FOIL

### BACKGROUND OF THE INVENTION

(a) Field of the Invention

This invention relates to an invar composite foil laminated by electrodeposition.

(b) Description of the Prior Art

Invar (alloy of 64% Fe and 36% Ni) is known as a material which has a very small coefficient of thermal expansion. A material for printed circuit boards which is composed of this invar and copper and has a very small coefficient of thermal expansion is proposed by Texas Instruments Inc. This composite foil is made by cladding copper (C) on both sides of rolled invar foil (I) and called CIC for short. Printed circuit boards using CIC as the composite foil have an equal coefficient of thermal expansion to that of almina ceramic and then the reliability of direct surface mount of IC chips against repeated thermal stresses is highly increased.

Another composite foil made of an invar and a copper layers laminated by electrodeposition is proposed in a European patent application (publication number 0224922) of Perstorp Inc. of Sweden.

There are the following problems with CIC due to being manufactured by rolling, The manufacturing cost is comparatively high. Broad foil greater than 600 mm is difficult to produce. CIC cannot be worked into laminated foil 1,000 to 1,200 mm in breadth which is commonly used for printed circuit boards. Furthermore, it contains oil which comes from the rolling process. So, rolled invar has some problems to be worn into laminated foil.

On the other hand, broader and oil-free composite foil can be produced by the method of Perstorp Inc. However, the foil made by electrodepositing invar on one side of copper foil or by electrodepositing copper on one side of the invar foil which is electrodeposited on the surface of a stainless steel drum and stripped from the drum and CIC made by further electrodepositing copper on the invar of the foil sharply curl due to the strain resulting from the internal stress caused by deposited invar whose contraction stress is greater than that of copper foil. Therefore, there is a serious handling problem in the manufacturing and working process with this composite foil and those made using this foil.

### SUMMARY OF THE INVENTION

An object of the present invention is to provide an invar composite foil which is broader, oil-free, and easy to handle in manufacturing and working process.

The present invention provides an invar composite foil made by electrodepositing invar on both sides of a metal foil at the same time and one with copper further electrodeposited on at least one of the invar layers.

The core metal foil may be copper, aluminium, nickel, or ferroalloy foil according to the application of the composite foil.

### DETAILED DESCRIPTION OF THE INVENTION

The invar composite foil of the present invention is made by laminating invar layers on both sides of core metal foil at the same time using electrodeposition. Therefore, the strains on both sides of the metal foil resulting from the stress caused by deposition of invar balance with each other and curling of the foil is suppressed. In addition to the above effect, since the thickness of each layer may be half the total thickness required, the strain decreases so much.

The coefficient of thermal expansion of composite foil is generally determined by the ratio of the thickness of the components. Then composite foil made of copper, invar, and copper of 20, 60, and 20 microns in thickness has the same coefficient of thermal expansion as composite foil made of invar, copper, and invar of 30, 40, 30 microns in thickness for example. However, the latter is much improved in respect of warp compared to the former and the handling problem is practically solved. For composite foil used for printed circuit boards, it is preferable to further electrodeposite copper on at least one of the invar layers. By this additional process, a circuit etched conductor which can be strongly sticked with a dielectric substrate can be obtained.

The core metal foil can be aluminium, nickel, or ferroalloy foil for composite foil used for measuring instruments, shadow masks of CRT, and other applications in which a small coefficient of thermal expansion is required.

Shown below are embodiments of the invar composite foil of the present invention. These embodiments are for illustrative purpose only and not intended to limit the invention in any way.

Example 1

Sample invar composite foil was prepared using 35 microns electrolytic copper foil for the cathode, ferronickel alloy for the anode, and an electrolytic bath of the following composition and electrolyzing with the current density of 10 A/dm² at the liquid temperature of 50 C. Invar was deposited 50 microns thick on both sides of the copper foil at the cathode.

| Ferrous sulfate | Fe 24g/l |
|---|---|

| Nickel chloride | Ni 85g/l |
|---|---|
| Boric acid | 40g/l |
| Critic acid | 25g/l |
| Ascorbic acid | 1g/l |
| pH | 2.5 |

The coefficient of thermal expansion of this composite foil was $5 \times 10^{-6}/°C$.

Example 2

Copper was further deposited 5 microns thick on both sides of the composite foil made by embodiment 1 using an acid sulfate bath. The foil was next sticked with epoxy resin-impregnated glass cloth and then heated under pressure to cure. Thus a laminated board 1.6 mm thick was obtained. The tear-off strength of this composite foil was 2 kg/cm.

As described above, the invar composite foil of the present invention has the following advantages.

(a) The copper and invar do not contain oil as they are formed by electrodeposition. Therefore, the composite foil of this invention is suitable for printed circuit boards.

(b) Broad products of 1,000 to 1,200 mm in breadth can be manufactured by using metal foil of an appropriate breadth as necessary. The thickness of products can also be precisely controlled.

(c) Since invar is electrodeposited on both sides of metal foil at the same time, the strains on both sides of the metal foil caused by deposited invar balance against each other and curling of the composite foil are almost completely suppressed. Thus virtually flat and easy to handle composite foil can be mass-produced at a low cost.

(d) The coefficient of thermal expansion of the composite foil of the present invention can be made less than $5 \times 10^{-6}/°C$. Therefore, the invar composite foil of the present invention is highly useful for printed circuit boards on which IC chips are directly surface-mounted as well as for various tools and instruments for which a small coefficient of thermal expansion is required.

**Claims**

1. An invar composite foil made by electrodepositing invar on both sides of metal foil at the same time.

2. An invar composite foil made by electrodepositing invar on both sides of metal foil and further electrodepositing copper on at least one of the invar layers.

3. An invar composite foil according to claim 1, wherein the metal foil is copper foil.

4. An invar composite foil according to claim 2, wherein the metal foil is copper foil.